Europäisches Patentamt

European Patent Office

Office européen des brevets

(11) Numéro de publication: **0 217 471 B1**

(12) **FASCICULE DE BREVET EUROPEEN**

(45) Date de publication de fascicule du brevet:
13.03.91

(51) Int. Cl.⁵: **H01L 23/48**

(21) Numéro de dépôt: **86201669.8**

(22) Date de dépôt: **29.09.86**

(54) **Dispositif semi-conducteur de puissance pour montage en surface.**

(30) Priorité: **01.10.85 FR 8514537**

(43) Date de publication de la demande:
**08.04.87 Bulletin 87/15**

(45) Mention de la délivrance du brevet:
**13.03.91 Bulletin 91/11**

(84) Etats contractants désignés:
**DE FR GB IT NL**

(56) Documents cités:
**EP-A- 0 034 001**
**US-A- 3 829 598**

**PATENTS ABSTRACTS OF JAPAN, vol. 8, no. 226 (E-272)[1663], 17 octobre 1984; & JP-A-59 108 334 (TOSHIBA K.K.) 22-06-1984**

**PATENTS ABSTRACTS OF JAPAN, vol. 8, no. 139 (E-253)[1576], 28 juin 1984; & JP-A-59 47 747 (HITACHI SEISAKUSHO K.K.) 17-03-1984**

(73) Titulaire: **PHILIPS COMPOSANTS**
**117, quai du Président Roosevelt**
**F-92130 Issy les Moulineaux(FR)FR**

Titulaire: **N.V. Philips' Gloeilampenfabrieken**
**Groenewoudseweg 1**
**NL-5621 BA Eindhoven(NL)DE GB IT NL**

(72) Inventeur: **Vertongen, Bernard**
**SOCIETE CIVILE S.P.I.D. 209, rue de l'Université**
**F-75007 Paris(FR)**
Inventeur: **Papoular, André**
**SOCIETE CIVILE S.P.I.D. 209, rue de l'Université**
**F-75007 Paris(FR)**

(74) Mandataire: **Jacquard, Philippe et al**
**Société Civile S.P.I.D. 156, Boulevard Haussmann**
**F-75008 Paris(FR)**

## Description

La présente invention concerne un dispositif semi-conducteur de puissance comportant au moins une pastille semi-conductrice enrobée dans un corps de matériau isolant et en contact thermique et électrique avec une plage centrale métallique se prolongeant par une plaquette métallique dissipatrice de la chaleur s'étendant longitudinalement à partir d'une première face latérale dudit corps et présentant des découpes formant des pattes, une deuxième face latérale dudit corps opposée à la première présentant des broches conductrices s'étendant longitudinalement.

De tels dispositifs, par exemple celui décrit dans la demande de brevet européenne 34 001, sont largement utilisés par exemple sous la forme de composants sous boîtier TO 220 et conviennent à une technique de montage classique, c'est-à-dire que les broches traversent des trous d'un circuit imprimé et sont soudées à leur extrémité libre.

L'évolution actuelle des techniques conduit de plus en plus à privilégier le montage en surface plus particulièrement par soudure à la vague. Dans cette technique, le corps du boîtier est collé sur le circuit imprimé pour le maintenir en place lors de l'opération de soudure à la vague, au cours de laquelle l'extrémité des broches du circuit est mouillée localement par effet capillaire en emprisonnant une très petite quantité de soudure. On connaît par exemple des boîtiers plats ("flat pack") pour montage en surface des demandes de brevet japonais JP-A-59 108 334 et JP-A-5 947 747.

Les composants de puissance sont actuellement exclus du montage en surface, ce qui fait que les microcircuits hybride sont assemblés en partie en technologie différente.

Du fait de la spécificité de la technique du montage en surface, l'homme du métier est conduit à penser qu'un dispositif pour montage en surface ne peut être réalisé qu'en s'inspirant de dispositifs pour montage en surface déjà connus.

L'invention se propose au contraire de résoudre le problème en adaptant le dispositif précité à la technique du montage en surface, plus particulièrement par soudure à la vague, tout en modifiant le moins possible sa structure mais en modifiant par contre notablement la fonction de cette structure de telle manière que les boîtiers utilisables pour le montage classique et le montage en surface puissent être fabriqués selon la même technique et avec le même outillage.

D'autre part, le dispositif selon l'invention est conçu de manière à présenter de bonnes performances d'évacuation thermique.

L'idée de base de l'invention consiste à souder la plaquette dissipatrice sur une majeure partie de sa surface pour obtenir un couplage électrique et thermique avec une métallisation d'un substrat, par l'intermédiaire d'une mince couche de soudure, grâce à un effet de capillarité.

Le dispositif semiconducteur de puissance selon l'invention est à cet effet caractérisé en ce que les broches et les pattes sont cambrées en direction d'une face dite inférieure dudit corps de manière à dépasser de celle-ci et d'une face inférieure de la plaquette dissipatrice, le dépassement des pattes par rapport à cette dernière étant tel que, lors d'une opération de montage en surface du dispositif par soudure à la vague sur un substrat, une quantité de soudure se trouve emprisonnée par capillarité sous la plaquette de telle sorte que celle-ci se trouve sur une majeure partie de la surface de la plaquette en contact électrique et thermique avec une métallisation dudit substrat.

Le dépassement de l'extrémité des pattes par rapport au plan inférieur de la plaquette dissipatrice est de préférence compris entre 0,1 et 0,2 mm.

Selon un mode de réalisation, le plan de la plaquette présente une face inférieure pratiquement coplanaire avec la face inférieure du corps.

Comme la plaquette dissipatrice est soudée sur une métallisation du substrat, elle peut être utilisée comme sortie électrique, les broches constituant d'autres sorties électriques non en contact avec celle-ci.

L'invention sera mieux comprise à la lecture de la description qui va suivre donnée à titre d'exemple non limitatif, en liaison avec les dessins qui représentent :

- la figure 1a, une vue de face d'une bande pré-découpée selon l'art antérieur ;
- la figure 1b, une coupe AA d'une telle bande, après cambrage des pattes selon l'art antérieur.
- la figure 2, un dispositif semi-conducteur de puissance enrobé, selon l'art antérieur, réalisé à partir de la bande des figures 1a et 1b ;
- la figure 3a, un dispositif semi-conducteur de puissance enrobé, selon le mode préféré de l'invention, et réalisé à partir de la bande découpée de la figure 1a ;
- la figure 3b, une coupe longitudinale du dispositif de la figure 3a, dans un plan décalé latéralement de manière à faire apparaître les broches subsistantes sans faire apparaître le résidu de la broche centrale découpée.
- la figure 4, une vue latérale du montage du dispositif de la figure 3a par soudure à la vague.

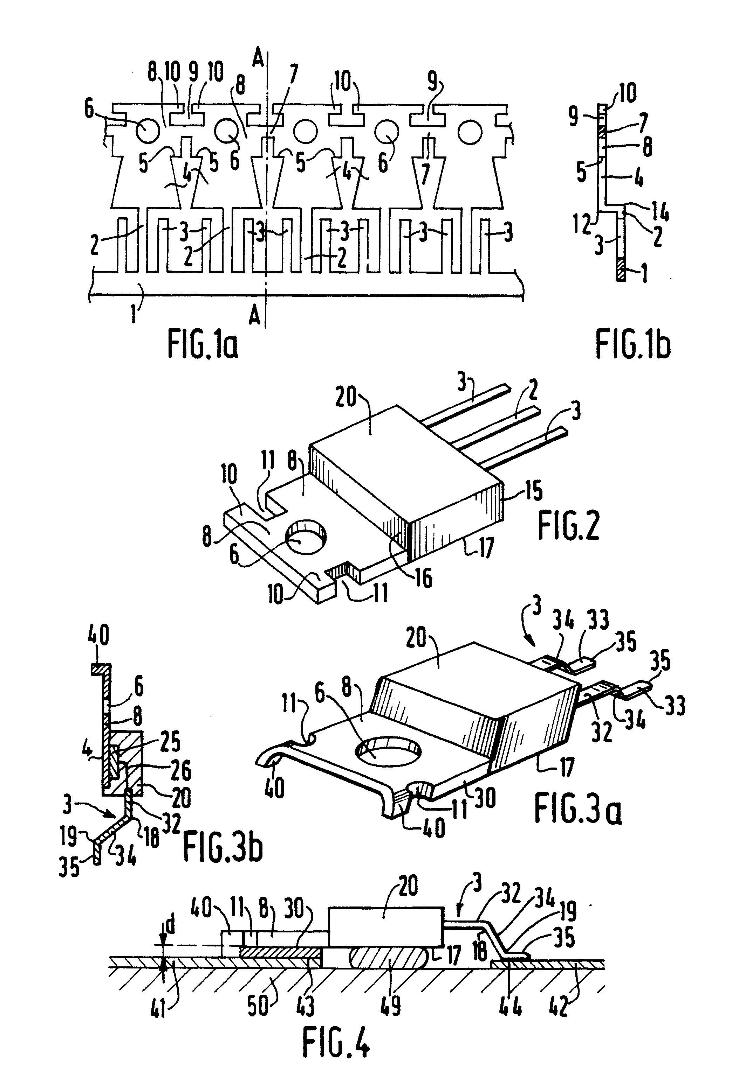

Selon la figure 1a, une bande conductrice pré-découpée d'un type connu pour la réalisation de boîtiers TO 220 standard commercialisés par la Demanderesse comporte des motifs identiques répétés longitudinalement et comportant chacun une plage centrale 4, sur laquelle sera ultérieurement soudée une pastille semi-conductrice de puissance. Cette plage centrale 4 de forme généralement trapézoïdale se prolonge au delà d'un décrochement 5 par une plaquette dissipatrice 8 percée d'un trou central 6 utilisé à des fins de fixation mécanique. La plage centrale 4 comporte à son extrémité opposée à la plaquette dissipatrice 8 une broche centrale 2. Les extrémités des broches 2 opposées à la plage centrale 4 sont solidarisées mécaniquement par une bande longitudinale 1 portant des paires de broches latérales 3 encadrant chacune des pattes centrales 2 et plus courtes que celles-ci. Les plaquettes dissipatrices 8 sont par ailleurs reliées entre elles par des languettes 7. Les languettes 7 ainsi que des broches 10 prolongeant le bout des plaquettes 8 sont délimitées par une découpe 9 en forme de T inversé. La bande prédécoupée est obtenue à partir d'une bande laminée en double épaisseur, ce qui permet d'obtenir une épaisseur plus faible pour les broches 2 et 3 et la bande longitudinale 1.

Le dispositif enrobé est réalisé de la manière suivante à partir de la bande pré-découpée de la figure 1a :

- cambrage des broches 2 à 90° dans un sens en 12 et à 90° dans l'autre sens en 14 de manière à décaler leur plan ainsi que celui des broches 3 par rapport à celui des plages centrales 4 (voir fig. 1b).

- soudure des pastilles semi-conductrices de puissance sur les plages centrales 4 donc en contact électrique et thermique avec celles-ci, et soudure des fils de connexion entre chaque pastille et les pattes latérales 3

- enrobage collectif isolant des plages centrales 4 avec leurs pastilles semi-conductrice et les fils de connexions, en laissant dépasser les extrémités des broches 2 et 3 et la plaquette dissipatrice 8.

- découpe des composants individuels avec élimination des languettes 7, et de la bande 1 de manière à obtenir le dispositif de la figure 2.

Ce dispositif présente donc un corps isolant d'enrobage 20 dont une face latérale 15 comporte une broche centrale 2 et deux broches latérales 3 et la face latérale opposée 16 une plaquette dissipatrice 8 présentant des découpes 11 délimitant des pattes 10.

Un tel dispositif est utilisé pour un montage de type classique sur un circuit imprimé.

L'invention se propose donc d'adapter ce dispositif au montage en surface avec un minimum de modifications ce qui permet de partir de la même bande pré-découpée (fig. 1a) mise en oeuvre dans l'art antérieur.

Selon les figures 3a et 3b, le dispositif selon l'invention permet une adaptation particulièrement avantageuse au montage en surface par introduction d'une étape de cambrage supplémentaire de préférence après enrobage et découpe des dispositifs individuels, c'est à dire en partant du composant préexistant de la fig. 2 sous boîtier standard TO 220, et en utilisant un équipement standard.

L'idée de base de l'invention consiste à mettre à profit les pattes 10 qui dans l'art antérieur n'avaient pour fonction que de dégager l'accès aux languettes 7 lors de leur découpe.

Les pattes 10 (maintenant référencées 40) sont cambrées de manière à dépasser de la face inférieure 17 du corps isolant 20. Elles dépassent de la plaquette dissipatrice 8 d'une distance permettant lors d'une opération de soudure à la vague décrite plus loin l'accumulation par effet capillaire d'une quantité de soudure 43 sous la majeure partie de la plaquette dissipatrice 8. Du fait que cette accumulation a lieu par effet capillaire sur une surface nettement supérieure à celle d'une goutte de soudure, la soudure 43 forme une mince couche. En outre, les broches 2 et 3 subissent deux pliages supplémentaires inverses l'un de l'autre en 18 et 19 chacun selon un angle qui peut être de l'ordre de 45°, de telle sorte qu'elles dépassent de la face inférieure 17 du corps 20 de manière à être dans le même plan que l'extrémité des pattes 40. Les pattes 3 comportent une extrémité à souder 35, une partie plane 34 entre les pliages 18 et 19 et une extrémité 32 partiellement enrobée.

L'opération de cambrage s'effectue donc de préférence en partant d'un composant tel que celui de la figure 2. Un équipement standard maintient les broches au plus près du boîtier 20 (à une distance d'1 mm environ). Les broches peuvent être alors cambrées à une distance de 5 à 6 mm environ du boîtier 20. Comme le contact électrique des broches 2 est réalisé au niveau des plaquettes 8, il n'est plus nécessaire de conserver celles-ci sauf si une sortie électrique de tous les contacts sur un même côté du boîtier est imposé par le client. Une opération de découpe est alors réalisée en même temps que le cambrage et également avec un matériel standard de manière à éliminer la broche 2 en la coupant aussi près que possible du corps 20. On obtient ainsi le mode de réalisation préféré représenté aux figures 3a et 3b. La plaquette dissipatrice 8 en contact électrique et thermique avec une pastille semiconductrice 20 constitue une sortie électrique et les broches 3 constituent d'autres sorties électriques non en contact électrique avec celle-ci. Les broches 3 sont reliées par des fils 26 avec des contacts électriques de la pastille 20 soudée sur la plaquette 8.

Selon la figure 4, le corps 20 est solidarisé au niveau de la partie 4 par de la colle 49 résistant à la température à la surface d'un substrat 50 par exemple d'un circuit imprimé portant des métallisations 41 et 42. Cette fixation provisoire par la colle 49 permet de manière connue de maintenir en place le dispositif pendant une opération ultérieure de soudure à la vague pour laquelle le circuit est renversé. Au cours de cette opération, les extrémités 35 des pattes 3 sont soudées à une métallisation 42, et la plaquette dissipatrice 8 à une métallisation 41 qui s'étend en regard de la plaquette 8 et au delà de celle-ci.

Le dépassement d de l'extrémité 40' des pattes 40 par rapport au plan inférieur 30 de la plaquette dissipatrice 8 a été choisi, ainsi qu'il a été mentionné plus haut, de manière qu'une mince épaisseur de soudure 43 soit, lors de l'opération de soudure à la vague, emprisonnée par capillarité sous une majeure partie de ladite plaquette, laquelle est pratiquement parallèle au plan de la métallisation 41. Ceci permet d'obtenir, en plus d'un bon contact électrique, et du fait que l'épaisseur de soudure est faible, un bon contact thermique entre la plaquette 8 et la métallisation 41. L'évacuation des calories ainsi facilitée sera d'autant meilleure que la soudure 43 s'étendra sur une surface plus importante. En effet, la mince couche d'air entre le dispositif et le substrat 50 a un effet pratiquement d'isolation thermique. A titre d'exemple, un dépassement d de 0,1 à 0,2 mm est susceptible d'apporter les meilleurs résultats quant aux propriétés capillaires et thermiques recherchées.

Il convient toutefois de noter que lors de l'opération de soudure à la vague, le petit volume d'air qui se trouve entre la plaquette 8 et la métallisation 41 doit être évacué pour laisser place à la soudure 43. La présence du trou central 6 favorise grandement la formation de la goutte de soudure 43 du fait qu'il procure un chemin supplémentaire d'accès au plan inférieur 30 de la plaquette 8.

Il est possible d'utiliser en variante une bande pré-découpée ne présentant pas de trous 6, mais au risque d'une mauvaise répartition de la soudure 43, de l'air pouvant rester emprisonné entre la plaquette 8 et la métallisation 41.

Cette variante obligerait en outre à utiliser une bande pré-découpée légèrement différente de celle de l'art antérieur.

## Revendications

1. Dispositif semi-conducteur de puissance comportant au moins une pastille semi-conductrice enrobée dans un corps de matériau isolant et en contact thermique et électrique avec une plage centrale métallique se prolongeant par une plaquette métallique dissipatrice de la chaleur et s'étendant longitudinalement à partir d'une première face latérale dudit corps et présentant des découpes formant des pattes, une deuxième face latérale dudit corps opposée à la première présentant des broches conductrices s'étendant longitudinalement caractérisé en ce que les broches (2, 3) et les pattes (10) sont cambrées en direction d'une face dite inférieure (17) dudit corps de manière à dépasser de celle-ci ainsi que d'un plan inférieur (30) de la plaquette dissipatrice (8), le dépassement (d) des pattes (10) par rapport à ce dernier (30) étant tel que, lors d'une opération de montage en surface du dispositif par soudure à la vague sur un substrat (50), une quantité de soudure (43) se trouve emprisonnée par capillarité sous la plaquette (8) de telle sorte que celle-ci se trouve sur une majeure partie de la surface de la plaquette (8) en contact électrique et thermique avec une métallisation (41) dudit substrat (50).

2. Dispositif selon la revendication 1, caractérisé en ce que le dépassement (d) de l'extrémité (40') des pattes (40) par rapport au plan inférieur (30) de la plaquette dissipatrice (8) est compris entre 0,1 et 0,2 mm.

3. Dispositif selon une des revendications 1 ou 2 caractérisé en ce que la plaquette (8) présente un trou central (6) destiné à faciliter la formation de la quantité de soudure (43) lors de l'opération de soudure à la vague.

4. Dispositif selon une des revendications 1 à 3 caractérisé en ce que la face inférieure (30) de la plaquette (8) est pratiquement coplanaire avec la face inférieure (17) du corps (20).

5. Dispositif selon une des revendications 1 à 4, caractérisé en ce que la plaquette dissipatrice (8) constitue une sortie électrique et en ce que les broches (3) constituent d'autres sorties électriques non en contact avec celle-ci.

## Claims

1. A power semiconductor device comprising at least one semiconductor wafer enveloped by a body of insulating material and in thermal and electrical contact with a central metal surface prolonged by a metal-heat dissipating plate and extending longitudinally from a first lateral surface of the said body and having cuts forming legs, a second lateral surface of the said body opposite to the first surface having conducting pins extending longitudinally, characterized in that the pins (2,3) and the legs (10) are bent in the direction of a socalled lower surface (17) of the said body in such a manner that they project beyond the latter and beyond a lower surface (30) of the dissipating plate (8), the distance ( d ) over which the legs (10) project beyond the latter (30) being such that during a surface mounting operation of the device by wave soldering on a substantially flat substrate (50) a quantity of solder (43) is enclosed by capillary action under the plate (8) in such a manner that this quantity of solder is over a major part of the surface of the plate (8) in electrical and thermal contact with a metallization (41) of the said substrate.

2. A device as claimed in Claim 1, characterized in that the distance of projection ( d ) of the ends of the legs (40) with respect to the lower surface (30) of the dissipating plate (8) lies between 0.1 and 0.2 mm.

3. A device as claimed in any one of the Claims 1 or 2, characterized in that the plate (8) has a central hole (6) intended to facilitate the formation of the quantity of the solder (43) during the wave soldering operation.

4. A device as claimed in any one of the Claims 1 to 3, characterized in that the lower surface (30) of the plate (8) is practically coplanar with the lower surface (17) of the body (20).

5. A device as claimed in any one of the Claims 1 to 4, characterized in that the dissipating plate (8) constitutes an electrical output and in that the pins (3) constitute other electrical outputs not in contact with the former.

## Ansprüche

1. Leistungshalbleiteranordnung mit mindestens einem Halbleiterchip, der in einen Körper aus isolierendem Material eingehüllt ist und mit einer zentralen Metallfläche in thermischem und elektrischem Kontakt steht, die in eine wärmeschluckende Metallplatte übergeht, die sich von einer ersten Seite des genannten Körpers in der Längsrichtung erstreckt und Ausnehmungen aufweist, die Zungen bilden, wobei eine zweite, der ersten Seite gegenüberliegende Seite des genannten Körpers sich in der Längsrichtung erstreckende Leitungsstifte aufweist, dadurch gekennzeichnet, daß die Stifte (2,3) und die Zungen (10) in Richtung der als Unterseite (17) bezeichneten Seite des genanten Körpers derart abgewinkelt sind, daß sie über diese Seite sowie eine Unterseite (30) der wärmeschluckenden Platte (8) hinausragen, wobei die Hinausragung (d) der Zungen (10) gegenüber dieser Seite (30) derart ist, daß bei einem Oberflächenmontagevorgang auf einer nahezu ebenen Oberfläche (50) der Anordnung durch Wellenlötung die Zungen eine bestimmte Lötmenge (43) durch Kapillarwirkung unterhalb der Platte (8) derart festhalten, daß diese Lötmenge über einen großen Teil der Oberfläche der Platte (8) mit einer Metallisierung (41) des genannten Substrats (50) in elektrischem und thermischem Kontakt steht.

2. Anordnung nach Anspruch 1, dadurch gekennzeichnet, daß die Hinausragung (d) der Enden der Zungen (40) über die untere Fläche (30) der wärmeschluckenden Platte (8) hinaus zwischen 0,1 und 0,2 mm beträgt.

3. Anordnung nach Anspruch 1 oder 2, dadurch gekennzeichnet , daß die Platte (8) eine Zentralöffnung (6) aufweist zur Erleichterung der Bildung der Lötmenge (43) beim Wellenlöten.

4. Anordnung nach einem der vorstehenden Ansprüche 1 bis 3, dadurch gekennzeichnet, daß die untere Fläche (30) der Platte (8) zu der unteren Fläche (17) der Körpers (20) nahezu koplanar ist.

5. Anordnung nach einem der vorstehenden Ansprüche 1 bis 4, dadurch gekennzeichnet, daß die wärmeschluckende Platte (8) einen elektrischen Ausgang bildet und die Stifte (3) andere, mit der genannten Platte nicht in Kontakt stehende elektrische Ausgänge bilden.

FIG.1a

FIG.1b

FIG.2

FIG.3b

FIG.3a

FIG.4